# EUROPEAN PATENT APPLICATION

(11) **EP 4 431 951 A1**
(43) Date of publication of application: **18.09.2024**
(21) Application number: 24156853.4
(22) Date of filing: 09.02.2024
(51) Int. Cl.: G01R 11/24, G01R 22/06

(54) **HIGH VOLTAGE/FREQUENCY TAMPER DETECTION CIRCUIT IN UTILITY METERS**

(30) Priority: 15.03.2023 IN 202311017349
(71) Applicant: Honeywell International Inc., Charlotte, NC 28202 (US)
(72) Inventor: SWAMINADHAN, Nikhail Pokkandath, Charlotte, 28202 (US); BAIJU, Arunima, Charlotte, 28202 (US)
(74) Representative: Haseltine Lake Kempner LLP

(57) **Abstract**

A tamper detection circuit comprising a trace antenna, an amplifier comprising an amplifier input terminal coupled to the trace antenna, and a comparator comprising (i) a first comparator input terminal coupled to an output terminal of the amplifier, (ii) a second comparator input terminal coupled to a voltage reference source, and (iii) a comparator output terminal configured to output a pulse signal based on voltage signals received at the first comparator input terminal and the voltage reference source.

## Description

### FIELD OF THE INVENTION

Example embodiments of the present disclosure relate generally to metering systems, and in particular, a detection circuit for detecting tampering of utility meters.

### BACKGROUND

Existing utility meters are prone to tampering by end users in attempts to halt or reduce measurement of resource consumption or service utilization by the end users. As such, measurement functionality of the utility meters may be hampered by causing the utility meters to malfunction or exhibit unintentional behavior resulting in inaccurate/incorrect readings. Applicant has identified many technical challenges and difficulties associated with preventing tampering of conventional meter devices.

### BRIEF SUMMARY

Various embodiments described herein relate to components, apparatuses, and systems for detecting tampering of meter devices.

In accordance with various embodiments of the present disclosure, a tamper detection circuit is provided. In some embodiments, the tamper detection circuit comprises a trace antenna, an amplifier comprising an amplifier input terminal coupled to the trace antenna, and a comparator comprising (i) a first comparator input terminal coupled to an output terminal of the amplifier, (ii) a second comparator input terminal coupled to a voltage reference source, and (iii) a comparator output terminal configured to output a pulse signal based on voltage signals received at the first comparator input terminal and the voltage reference source.

In some embodiments, the amplifier comprises an operational amplifier configured to amplify voltage signals received from the trace antenna. In some embodiments, the comparator comprises an operational amplifier configured to compare the voltage signals received at the first comparator input terminal to the voltage reference source.

According to another embodiment, a meter device is provided. In some embodiments, the meter device comprises a tamper detection circuit comprising a trace antenna, an amplifier, and a comparator, wherein the tamper detection circuit is configured to generate a pulse signal, a memory device having executable instructions stored therein, and a processor, in response to the executable instructions, configured to monitor the pulse signal from the tamper detection circuit, determine a tampering event based on the monitoring of the pulse signal, and generate an alarm condition based on the determination of the tampering event.

In some embodiments, the amplifier comprises an amplifier input terminal coupled to the trace antenna. In some embodiments, the comparator comprises (i) a first comparator input terminal coupled to an output terminal of the amplifier, (ii) a second comparator input terminal coupled to a voltage reference source, and (iii) a comparator output terminal configured to output a pulse signal based on voltage signals received at the first comparator input terminal and the voltage reference source. In some embodiments, the processor, in response to the executable instructions, is further configured to: analyze the pulse signal with respect to one or more criteria. In some embodiments, the one or more criteria comprise interval between pulses, duration of pulses, or frequency of pulses. In some embodiments, the processor, in response to the executable instructions, is further configured to: distinguish presence of high voltage/frequency tamper events from false detection events based on the one or more criteria.

According to another embodiment, a method for detecting meter device tampering is provided. In some embodiments, the method comprises monitoring a pulse signal from a tamper detection circuit, the tamper detection circuit comprising a trace antenna, an amplifier, and a comparator, determining a tampering event based on the monitoring of the pulse signal, and generating an alarm condition based on the determination of the tampering event.

The foregoing illustrative summary, as well as other exemplary objectives and/or advantages of the disclosure, and the manner in which the same are accomplished, are further explained in the following detailed description and its accompanying drawings.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example tamper detection circuit in accordance with various embodiments of the present disclosure;
FIG. 2 illustrates an example meter device in accordance with various embodiments of the present disclosure;
FIG. 3 illustrates an example monitoring server in accordance with various embodiments of the present disclosure; and
FIG. 4 illustrates a flowchart of an example method for detecting meter device tampering in accordance with various embodiments of the present disclosure.

### DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Meter devices may be installed on customer premises and used to measure and record consumption of resources or utilization of a service (e.g., electricity, gas, water, or any other utility service or resource) by end users. Readings of the meter devices may be either recorded physically by personnel who may periodically visit customer sites having such meter devices, or transmitted from the meter devices to a central server via power lines, dedicated signaling or network lines, a public telephone switched network (PTSN), or radio frequency (RF) transmissions.

As described above, there are many technical challenges and difficulties associated with existing meter devices. Application of electrostatic discharge (ESD) is a common technique that may be used to tamper with meter devices. A meter device can be tampered with devices, such as ignition coil or other electrostatic discharge (ESD) devices that generate spikes of voltages of 35 kV and above with unknown frequency and wave shape. High voltage/frequency generated from ESD may induce errors in consumption recording or damage a meter device. Such tampering is difficult to detect and is problematic for utility providers. To protect a meter device from ESD, a metal plate shield may be used to house electronic components and circuits within a meter device. However, it is still desirable to be able to detect such tampering for the purposes of auditing and penalizing end users who attempt to tamper with meter devices.

Various example embodiments of the present disclosure overcome such technical challenges and difficulties in detecting high voltage/frequency tampering of meter devices, and provide various technical advancements and improvements. In accordance with various examples of the present disclosure, components of an example circuit for detecting high voltage/frequency tampering are disclosed. In particular, a small form factor electronic circuit may be provided for detecting high voltage/frequency radiation from sparks produced by a tamper device and may be used to determine the presence of tampering.

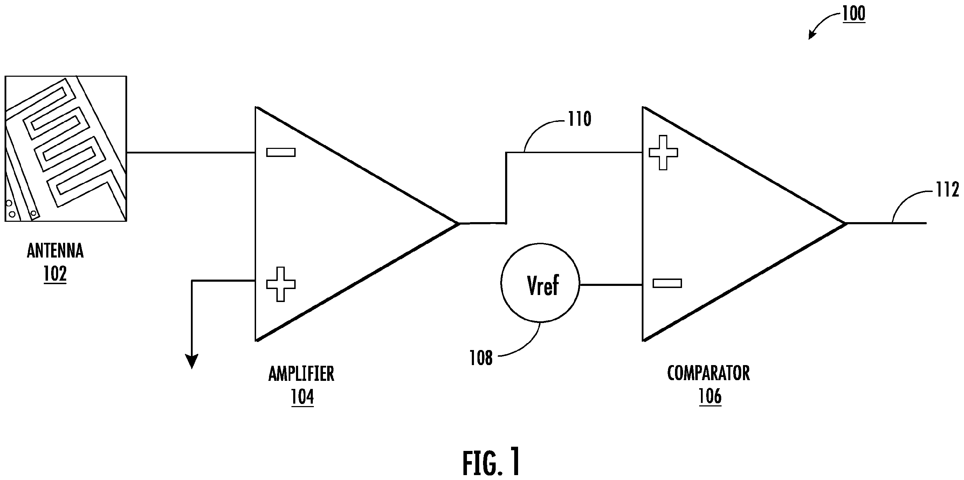

Referring now to FIG. 1, a tamper detection circuit 100 is provided, which may be used in accordance with various embodiments of the present disclosure. Tamper detection circuit 100 comprises antenna 102, amplifier 104, and a comparator 106. In some embodiments, antenna 102 may comprise a trace antenna. A trace antenna may comprise a metal trace printed or drawn on a top layer of a printed circuit board (PCB) to provide a wireless communication interface for receiving electromagnetic waves. The trace of trace antenna may comprise a geometric pattern in a width and length to provide a given impedance and frequency range. In another example embodiments, antenna 102 may comprise a chip antenna.

The usage of an internal antenna, such as antenna 102 may obviate the need for an antenna to be in direct contact with external tampering and prevent system damage due to introduction of, for example, high voltage sparks to circuit components. In some embodiments, tamper detection circuit 100 may comprise devices, such as transient-voltage-suppression diodes or ferrite beans, to prevent damage and ensure functionality even in case of direct high voltage/frequency exposure. Furthermore, tamper detection circuit 100 may be configured within a housing of a meter device. As such, antenna 102 can detect presence of radiation or electromagnetic waves, e.g., indicative of potential tampering, caused by discharge of a high voltage/frequency spark (e.g., a ESD tamper device) or an electromagnetic source. In some embodiments, the antenna 102 may be configured to detect over a wide frequency band to provide greater reception coverage of radiation or electromagnetic waves that may be unknown or of various frequencies.

Antenna 102, in response to radiation detection, may generate voltage signals, for example, in the range of micro or milli volts, proportional to radiation detected by the antenna 102. Voltage signals may be transferred from antenna 102 to amplifier 104. Amplifier 104 may be configured to step up or increase low-amplitude voltage signals from the antenna 102 to a required level for monitoring or processing by, for example a microcontroller/processor.

Amplifier 104 may comprise an operational amplifier configured to amplify voltage signals from the antenna 102. It is noted that amplifier 104 is merely depicted as comprising an open loop configuration for the purposes of illustration and amplifier 104 is not limited to an open loop configuration. For example, amplifier 104 may be configured with feedback (either inverting or non-inverting) to control the gain of amplifier 104. In some example embodiments, amplifier 104 may be configured in an inverting configuration comprising a negative feedback to amplify a voltage signal at a negative input terminal of amplifier 104 with a specific gain. Configuring amplifier 104 in an inverting configuration may provide high common mode rejection ratio (CMRR) and low input impedance which in turn reduces noise voltage drop. The negative feedback may be applied by connecting one or more feedback resistors with specific impedance values across the amplifier 104 from amplifier output terminal 110 back to the negative input terminal of amplifier 104 to achieve a desired gain. In some embodiments, the one or more feedback resistors may comprise a potentiometer such that the gain of amplifier 104 may be adjusted to fine tune detection sensitivity.

The amplifier 104 may generate amplified voltage signals of the antenna 102 at amplifier output terminal 110. The amplifier output terminal 110 is coupled to a positive input terminal of comparator 106. Comparator 106 may comprise an operational amplifier configured to compare voltage signals from amplifier output terminal 110 to a reference voltage source (Vref) 108 coupled to a negative input terminal of compactor 106. Comparator 106 may generate an output signal based on the voltage comparison between the positive input terminal and the negative input terminal of the comparator 106.

Comparator 106 may be used, for example, to determine whether a voltage signal from amplifier output terminal 110 has reached some predetermined value. For example, the presence of mobile radiations, human ESD, high frequency harmonics in supply voltage/current, and similar unintended detection sources can lead to false-detection of tampering. As such, Vref 108 may comprise a predefined voltage threshold greater than voltages values associated with false-detection events. The comparator 106 may further comprise a negative supply voltage (e.g., -Vcc) and a positive supply voltage (e.g., +Vcc). If a voltage provided by amplifier output terminal 110 to comparator 106 is less than Vref 108, comparator 106 may generate a "low" output associated with the negative supply voltage. On the other hand, if a voltage provided by amplifier output terminal 110 to comparator 106 is greater than Vref 108, comparator 106 may generate a "high" output associated with the positive supply voltage.

In some embodiments, the comparator 106 may generate pulse signals based on voltage signals received from amplifier output terminal 110 in comparison to Vref 108. Pulse signals generated by comparator 106 may be transmitted as input to a microcontroller or processor via comparator output terminal 112 for analysis. For example, pulses in pulse signals generated by comparator 106 may be analyzed by counting and monitoring with respect to certain criteria, such as interval between the pulses, duration of the pulses, and frequency of the pulses. Based on the analysis with respect to one or more criteria, the microcontroller or processor may detect and distinguish the presence of high voltage/frequency tamper events from false detection events (or unintended detection sources, such as mobile radiations, human ESD, high frequency harmonics in supply voltage/current).

The tamper detection circuit 100 may be embodied as a small form factor PCB circuit and configured within a meter device in an optimized location for tamper detection. For example, the optimized location may be a location within a meter device where tamper detection circuit 100 is able to, for example, provide a maximum of high voltage/frequency radiation detection coverage with respect to the surfaces of the meter device.

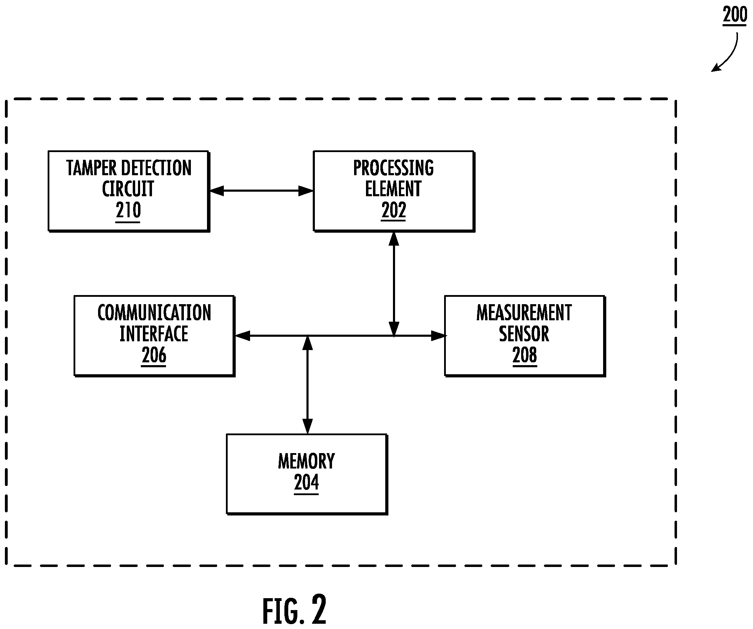

FIG. 2 depicts an example meter device 200 in accordance with various embodiments of the present disclosure. Meter device 200 may be configured to record and transmit data associated with consumption of a resource or service, such as gas, water, or electricity, to a monitoring server.

As shown in FIG. 2, the meter device 200 includes processing element 202 (also referred to as a processor, processing circuitry, and/or similar terms used herein interchangeably) that communicates with other elements within the meter device 200 via a bus, for example. As will be understood, the processing element 202 may be embodied in a number of different ways. For example, the processing element 202 may be embodied as one or more complex programmable logic devices (CPLDs), microprocessors, multi-core processors, coprocessing entities, application-specific instruction-set processors (ASIPs), microcontrollers, and/or controllers. Further, the processing element 202 may be embodied as one or more other processing devices or circuitry. The term circuitry may refer to an entirely hardware embodiment or a combination of hardware and computer program products. Thus, the processing element 202 may be embodied as integrated circuits, application specific integrated circuits (ASICs), field programmable gate arrays (FPGAs), programmable logic arrays (PLAs), hardware accelerators, other circuitry, and/or the like. As will therefore be understood, the processing element 202 may be configured for a particular use or configured to execute instructions stored in volatile or non-volatile media or otherwise accessible to the processing element 202. As such, whether configured by hardware or computer program products, or by a combination thereof, the processing element 202 may be capable of performing steps or operations according to embodiments of the present disclosure when configured accordingly.

Meter device 200 further includes memory 204 comprising non-volatile media (also referred to as non-volatile storage, memory, memory storage, memory circuitry and/or similar terms used herein interchangeably).In some embodiments, non-volatile media may include, but not limited to, hard disks, ROM, PROM, EPROM, EEPROM, flash memory, MMCs, SD memory cards, Memory Sticks, CBRAM, PRAM, FeRAM, NVRAM, MRAM, RRAM, SONOS, FJG RAM, Millipede memory, racetrack memory, and/or the like. Memory 204 may also comprise volatile media (also referred to as volatile storage, memory, memory storage, memory circuitry and/or similar terms used herein interchangeably). In some embodiments, volatile media may include, but not limited to, RAM, DRAM, SRAM, FPM DRAM, EDO DRAM, SDRAM, DDR SDRAM, DDR2 SDRAM, DDR3 SDRAM, RDRAM, TTRAM, T-RAM, Z-RAM, RIMM, DIMM, SIMM, VRAM, cache memory, register memory, and/or the like.

As will be recognized, memory 204 may be used to store at least portions of the databases, database instances, database management systems, data, applications, programs, program modules, scripts, source code, object code, byte code, compiled code, interpreted code, machine code, executable instructions, and/or the like being executed by, for example, the processing element 202. Thus, the databases, database instances, database management systems, data, applications, programs, program modules, scripts, source code, object code, byte code, compiled code, interpreted code, machine code, executable instructions, and/or the like may be used to control certain aspects of the operation of the meter device 200 with the assistance of the processing element 202 and operating system.

The meter device 200 further includes a communication interface 206 for communicating with various computing entities, such as by communicating data, content, information, and/or similar terms used herein interchangeably that can be transmitted, received, operated on, processed, displayed, stored, and/or the like. Such communication may be executed using a wired data transmission protocol, such as fiber distributed data interface (FDDI), digital subscriber line (DSL), Ethernet, asynchronous transfer mode (ATM), frame relay, data over cable service interface specification (DOCSIS), or any other wired transmission protocol. Similarly, the meter device 200 may be configured to communicate via wireless external communication networks using any of a variety of protocols, such as general packet radio service (GPRS), Universal Mobile Telecommunications System (UMTS), Code Division Multiple Access 2000 (CDMA2000), CDMA2000 1X (1xRTT), Wideband Code Division Multiple Access (WCDMA), Global System for Mobile Communications (GSM), Enhanced Data rates for GSM Evolution (EDGE), Time Division-Synchronous Code Division Multiple Access (TD-SCDMA), Long Term Evolution (LTE), Evolved Universal Terrestrial Radio Access Network (E-UTRAN), Evolution-Data Optimized (EVDO), High Speed Packet Access (HSPA), HighSpeed Downlink Packet Access (HSDPA), IEEE 802.11 (Wi-Fi), Wi-Fi Direct, 802.16 (WiMAX), ultra-wideband (UWB), infrared (IR) protocols, near field communication (NFC) protocols, Wibree, Bluetooth protocols, wireless universal serial bus (USB) protocols, and/or any other wireless protocol.

Meter device 200 further includes measurement sensor 208. Measurement sensor 208 may comprise a device that detects and responds to an input from a physical environment, such as light, heat, motion, moisture, pressure or any number of other environmental phenomena. In some embodiments, meter device 200 may be configured to detect and measure consumption of a resource or service, such as gas, water, or electricity.

The meter device 200 also includes a tamper detection circuit 210. Tamper detection circuit may be configured to receive environmental radiation and generate pulse signals based on the environmental radiation. Pulse signals generated by the tamper detection circuit 210 may be transmitted to processing element 202 for analysis and determination for presence of high voltage/frequency events indicative or representative of tampering. For example, the tamper detection circuit 210 may be similar to tamper detection circuit 100 described above with regard to FIG. 1.

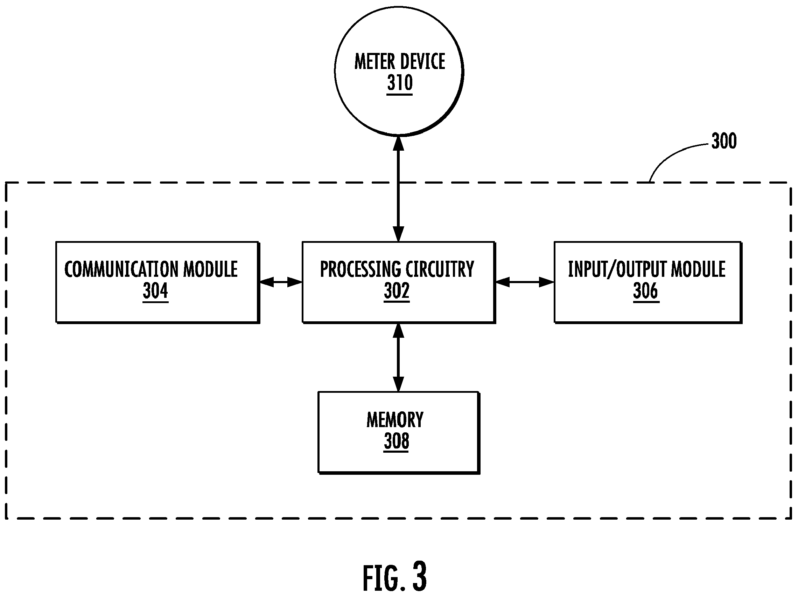

FIG. 3 depicts a schematic diagram depicting an example monitoring server 300 of an example head-end system in electronic communication with various other components in accordance with various embodiments of the present disclosure. As shown, the monitoring server 300 comprises processing circuitry 302, a communication module 304, input/output module 306, a memory 308 and/or other components configured to perform various operations, procedures, functions or the like described herein.

As shown, the monitoring server 300 (such as the processing circuitry 302, communication module 304, input/output module 306 and memory 308) is electrically coupled to and/or in electronic communication with a meter device 310. As depicted, the meter device 310 may exchange (e.g., transmit and receive) data with the processing circuitry 302 of the monitoring server 300. The meter device 310 may be similar to meter device 200 described above with regard to FIG. 2. For example, meter device 310 may record data associated with consumption of a resource or service and transmit the data to the processing circuitry 302.

The processing circuitry 302 may be implemented as, for example, various devices comprising one or a plurality of microprocessors with accompanying digital signal processors; one or a plurality of processors without accompanying digital signal processors; one or a plurality of coprocessors; one or a plurality of multi-core processors; one or a plurality of controllers; processing circuits; one or a plurality of computers; and various other processing elements (including integrated circuits, such as ASICs or FPGAs, or a certain combination thereof). In some embodiments, the processing circuitry 302 may comprise one or more processors. In one exemplary embodiment, the processing circuitry 302 is configured to execute instructions stored in the memory 308 or otherwise accessible by the processing circuitry 302. When executed by the processing circuitry 302, these instructions may enable the monitoring server 300 to execute one or a plurality of the functions as described herein.

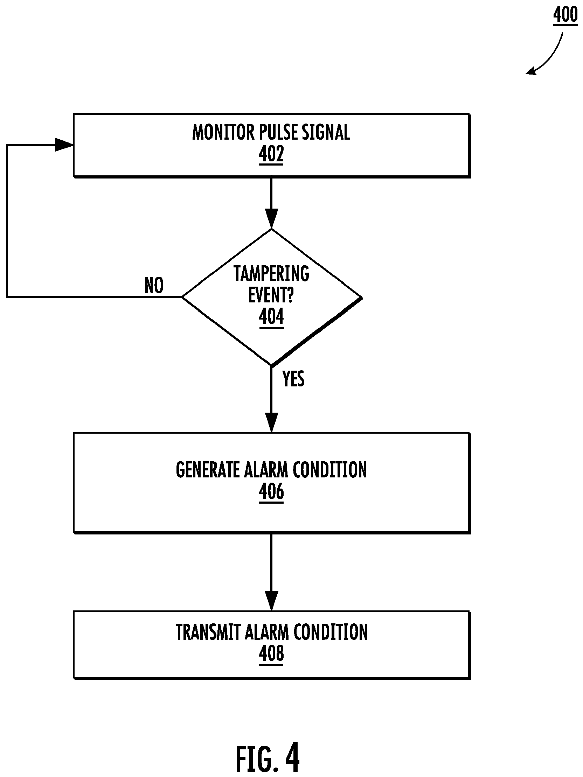

The processing circuitry 302 may comprise entities capable of executing operations according to the embodiments of the present disclosure. Therefore, for example, when the processing circuitry 302 is implemented as an ASIC, an FPGA, or the like, the processing circuitry 302 may comprise specially configured hardware for implementing one or a plurality of operations described herein. Alternatively, as another example, when the processing circuitry 302 is implemented as an actuator of instructions (such as those that may be stored in the memory 308), the instructions may specifically configure the processing circuitry 302 to execute one or a plurality of algorithms and operations described herein, such as those discussed with reference to FIG. 4.

The memory 308 may comprise, for example, a volatile memory, a non-volatile memory, or a certain combination thereof. In some embodiments, volatile memory may include, but not limited to, RAM, DRAM, SRAM, FPM DRAM, EDO DRAM, SDRAM, DDR SDRAM, DDR2 SDRAM, DDR3 SDRAM, RDRAM, TTRAM, T-RAM, Z-RAM, RIMM, DIMM, SIMM, VRAM, cache memory, register memory, and/or the like. In some embodiments, non-volatile memory may include, but not limited to, hard disks, ROM, PROM, EPROM, EEPROM, flash memory, MMCs, SD memory cards, Memory Sticks, CBRAM, PRAM, FeRAM, NVRAM, MRAM, RRAM, SONOS, FJG RAM, Millipede memory, racetrack memory, and/or the like.

Although illustrated as a single memory in FIG. 3, the memory 308 may comprise a plurality of memory components. In various embodiments, the memory 308 may comprise, for example, a random access memory, a cache memory, a flash memory, a circuit configured to store information, or a certain combination thereof. The memory 308 may be configured to store information, data, application programs, instructions, and etc., so that the monitoring server 300 can execute various functions according to the embodiments of the present disclosure. For example, in at least some embodiments, the memory 308 is configured to cache input data for processing by the processing circuitry 302. Additionally, or alternatively, in at least some embodiments, the memory 308 is configured to store program instructions for execution by the processing circuitry 302. The memory 308 may store information in the form of static and/or dynamic information. When the functions are executed, the stored information may be stored and/or used by the monitoring server 300.

The communication module 304 may be implemented as any apparatus included in a circuit, hardware, a computer program product or a combination thereof, which is configured to receive and/or transmit data from/to another component or apparatus. The computer program product comprises computer-readable program instructions stored on a computer-readable medium (for example, the memory 308) and executed by a monitoring server 300 (for example, the processing circuitry 302). In some embodiments, the communication module 304 (as with other components discussed herein) may be at least partially implemented as the processing circuitry 302 or otherwise controlled by the processing circuitry 302. In this regard, the communication module 304 may communicate with the processing circuitry 302, for example, through a bus. The communication module 304 may comprise, for example, antennas, transmitters, receivers, transceivers, network interface cards and/or supporting hardware and/or firmware/software, and is used for establishing communication with another apparatus. The communication module 304 may be configured to receive and/or transmit any data that may be stored by the memory 308 by using any protocol that can be used for communication between apparatuses. The communication module 304 may additionally or alternatively communicate with the memory 308, the input/output module 306 and/or any other component of the monitoring server 300, for example, through a bus.

In some embodiments, the monitoring server 300 may comprise an input/output module 306. The input/output module 306 may communicate with the processing circuitry 302 to receive instructions input by the user and/or to provide audible, visual, mechanical or other outputs to the user. Therefore, the input/output module 306 may comprise supporting devices, such as a keyboard, a mouse, a display, a touch screen display, and/or other input/output mechanisms. Alternatively, at least some aspects of the input/output module 306 may be implemented on a device used by the user to communicate with the monitoring server 300. The input/output module 306 may communicate with the memory 308, the communication module 304 and/or any other component, for example, through a bus. One or a plurality of input/output modules and/or other components may be included in the monitoring server 300.

In some embodiments, monitoring server 300 may receive a plurality of meter readings from one or more meter devices, such as meter device 200. The meter readings may comprise data associated with consumption of a resource or service, such as gas, water, or electricity. In addition to the plurality of meter readings, the monitoring server 300 may also receive alarm conditions associated with a detection of tampering of the one or more meter devices. The monitoring server may log instances of the alarm conditions into the memory 308 and track tampering activity associated with the one or more meter devices. In some embodiments, upon receiving alarm conditions associated with the detection of tampering, monitoring server 300 may generate notifications or messages of tamper presence in real time based on criticality. The notifications or messages may be accessible via input/output module 306.

Referring now to FIG. 4, a flowchart diagram illustrating example operations 400 in accordance with various embodiments of the present disclosure is provided. In some examples, the method 400 may be performed by a processing circuitry (for example, but not limited to, an application-specific integrated circuit (ASIC), a central processing unit (CPU)). In some examples, the processing circuitry may be electrically coupled to and/or in electronic communication with other circuitries of the example apparatus, such as, but not limited to, a humidity flow sensing component, a dehumidifier component, a gas detecting, a memory (such as, for example, random access memory (RAM) for storing computer program instructions), and/or a display circuitry (for rendering readings on a display).

In some examples, one or more of the procedures described in FIG. 4 may be embodied by computer program instructions, which may be stored by a memory (such as a non-transitory memory) of a system employing an embodiment of the present disclosure and executed by a processing circuitry (such as a processor) of the system. These computer program instructions may direct the system to function in a particular manner, such that the instructions stored in the memory circuitry produce an article of manufacture, the execution of which implements the function specified in the flow diagram step/operation(s). Further, the system may comprise one or more other circuitries. Various circuitries of the system may be electronically coupled between and/or among each other to transmit and/or receive energy, data and/or information.

In some examples, embodiments may take the form of a computer program product on a non-transitory computer-readable storage medium storing computer-readable program instruction (e.g., computer software). Any suitable computer-readable storage medium may be utilized, including non-transitory hard disks, CD-ROMs, flash memory, optical storage devices, or magnetic storage devices.

The example method 400 begins at step/operation 402. In some embodiments, at step/operation 402, a processing circuitry (such as, but not limited to, the processing element 202 of the meter device 200 illustrated in connection with FIG. 2, discussed above) monitors a pulse signal received from a tamper detection circuit (e.g., tamper detection circuit 210). The pulse signal may be generated based on a detection of environmental radiation by the tamper detection circuit.

In some embodiments, subsequent to step/operation 402, the example method proceeds to step/operation 404, where processing circuitry analyzes the pulse signal to determine whether a tampering event exists. Pulse signals generated by the tamper detection circuit may be transmitted to processing element 202 for analysis and determination for presence of high voltage/frequency events indicative or representative of tampering. For example, the pulse signals may be counted and monitored with respect to certain criteria, such as interval between the pulses, duration of the pulses, and frequency of the pulses. Based on the analysis with respect to one or more criteria, the processing element 202 may detect and distinguish the presence of high voltage/frequency tamper events from false detection events (or unintended detection sources, such as mobile radiations, human ESD, high frequency harmonics in supply voltage/current).

In some embodiments, subsequent to step/operation 404, if a tampering event does not exist, the example method returns to step/operation 402, where processing circuitry continues to monitor the pulse signal.

In some embodiments, subsequent to step/operation 404, if a tampering event exists, the example method proceeds to step/operation 406, where processing circuitry generates an alarm condition. Generating the alarm condition may comprise identifying characteristics associated with the tampering event and generating a data object comprising the identified characteristics. Identified characteristics associated with a tampering event may comprise a device identifier (ID) of the meter device, a type of tampering (e.g., ESD) distinguishing the identified tampering event from other kinds of tampering (e.g., physical tampering, jamming, or magnetic interference), or date/time of the tampering event.

In some embodiments, subsequent to step/operation 406, the example method proceeds to step/operation 408, where processing circuitry transmits the alarm condition to a monitoring server, such as monitoring server 300. The alarm condition may be transmitted to the monitoring server upon real-time or periodically along with meter readings (e.g., data associated consumption of a resource or service). The alarm condition associated with a detection of tampering of the meter device may be logged or recorded by the monitoring server and used to track tampering activity associated with the meter device.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

## Claims

1. A tamper detection circuit comprising:
a trace antenna;
an amplifier comprising an amplifier input terminal coupled to the trace antenna; and
a comparator comprising (i) a first comparator input terminal coupled to an output terminal of the amplifier, (ii) a second comparator input terminal coupled to a voltage reference source, and (iii) a comparator output terminal configured to output a pulse signal based on voltage signals received at the first comparator input terminal and the voltage reference source.

2. The tamper detection circuit of claim 1, wherein the amplifier comprises an operational amplifier configured to amplify voltage signals received from the trace antenna.

3. The tamper detection circuit of claim 1, wherein the comparator comprises an operational amplifier configured to compare the voltage signals received at the first comparator input terminal to the voltage reference source.

4. A meter device comprising:
a tamper detection circuit comprising a trace antenna, an amplifier, and a comparator, wherein the tamper detection circuit is configured to generate a pulse signal;
a memory device having executable instructions stored therein; and
a processor, in response to the executable instructions, configured to:
monitor the pulse signal from the tamper detection circuit;
determine a tampering event based on the monitoring of the pulse signal; and
generate an alarm condition based on the determination of the tampering event.

5. The meter device of claim 4, wherein the amplifier comprises an amplifier input terminal coupled to the trace antenna.

6. The meter device of claim 4, wherein the comparator comprises (i) a first comparator input terminal coupled to an output terminal of the amplifier, (ii) a second comparator input terminal coupled to a voltage reference source, and (iii) a comparator output terminal configured to output a pulse signal based on voltage signals received at the first comparator input terminal and the voltage reference source.

7. The meter device of claim 4, wherein the processor, in response to the executable instructions, is further configured to analyze the pulse signal with respect to one or more criteria.

8. The meter device of claim 7, wherein the one or more criteria comprises an interval between one or more pulses, a duration of the one or more pulses, or a frequency of the one or more pulses.

9. The meter device of claim 8, wherein the processor, in response to the executable instructions, is further configured to distinguish a presence of one or more high voltage/frequency tamper events from one or more false detection events based on the one or more criteria.

10. A method for detecting tampering of a meter device, the method comprising:
monitoring a pulse signal from a tamper detection circuit, the tamper detection circuit comprising a trace antenna, an amplifier, and a comparator;
determining a tampering event based on the monitoring of the pulse signal; and
generating an alarm condition based on the determination of the tampering event.

11. The method of claim 10, wherein the pulse signal is generated based on a detection of environmental radiation by the tamper detection circuit.

12. The method of claim 10, wherein the tampering event comprises a high voltage/frequency event.

13. The method of claim 10, wherein determining the tampering event comprises monitoring the pulse signal based on one or more criteria comprising an interval between one or more pulses, a duration of the one or more pulses, or a frequency of the one or more pulses.

14. The method of claim 10, wherein determining the tampering event comprises distinguishing a presence of one or more high voltage/frequency tamper events from one or more false detection events.

15. The method of claim 10, wherein generating the alarm condition further comprises:
identifying one or more characteristics associated with the tampering event; and
generating a data object comprising the one or more characteristics.
